# EUROPEAN PATENT SPECIFICATION

(11) **EP 0 552 667 B1**
(45) Date of publication and mention of the grant of the patent: **21.04.1999**
(21) Application number: 93100465.9
(22) Date of filing: 14.01.1993
(51) Int. Cl.: G06F 12/08, G11C 7/00

(54) **Enhanced dram with embedded registers**
DRAM mit integrierten Registern
DRAM avec registres intégrés

(30) Priority: 22.01.1992 US 824211
(43) Date of publication of application: 28.07.1993
(60) Divisional application: 98120219.5
(73) Proprietor: Enhanced Memory Systems, Inc., Colorado Springs, Colorado 80921 (US)
(72) Inventor: Sartore, Ronald H., Colorado Springs, CO 80132 (US); Carrigan, Donald G., Monument, CO 80132 (US); Jones, Oscar Frederick, Jr., Colorado Springs, CO 80919 (US); Mobley, Kenneth J., Colorado Springs, CO 80908 (US)
(74) Representative: Burke, Steven David

(56) References cited:
- DE-A- 4 118 804
- US-A- 4 943 944
- US-A- 5 025 421
- 1990 IEEE INTERNATIONAL CONFERENCE ON COMPUTER DESIGN: VLSI IN COMPUTERS & PROCESSORS 17 September 1990, CAMBRIDGE, MASS.; US pages 417 - 420 , XP201656 NIIJIMA ET AL. 'QRAM - Quick Access Memory System'
- ELECTRONIC DESIGN vol. 40, no. 2, 23 January 1992, HASBROUCK HEIGHTS, NEW JERSEY US pages 39 - 44 , XP290497 BURSKY 'Combination DRAM-SRAM Removes Secondary Caches'

## Description

The present invention relates to a dynamic random access memory ("DRAM") and more particularly to an Enhanced DRAM (which we call an "EDRAM") with embedded registers to allow fast random access to the DRAM while decoupling the DRAM from data processing operations.

As the personal computer ("PC") evolves, processor memory demands have out-paced the technology of available memory devices. One of these demands is high speed memory compatibility. Thus, memory subsystems have become an influential component toward the overall performance of a PC system. Emphasis is now on refining and improving memory devices that provide affordable, zero-wait-state operation.

With respect to memory speed, the static RAM is faster than the DRAM because the DRAM has a differential nature of the cells. In a static RAM, a differential circuit is employed directly and differential sensing is used. In a DRAM, differential techniques are used but a dummy cell or reference signal is used. Ordinarily there is no complementary data. A lesser factor is that the DRAM must refresh and precharge its memory cells whereas the static RAM need not. While the DRAM refreshes and precharges, access to the memory cells is prohibited. This creates an increase in access time, which drawback the static RAM does not suffer. On the other hand, the DRAM is less expensive and can achieve a higher density than the static RAM, owing at least in part to the smaller and simpler memory cell of the DRAM. For instance, static RAMs have a maximum traditionally of one-fourth the number of cells of a DRAM which uses the same technology.

However, the speed and functionality of current DRAMS are often emphasized less than memory size (storage capacity) and cost. This is evidenced by the fact that DRAM storage capacity density has increased at a rate of an order of magnitude greater than has its speed. While there has been some improvement in access time, systems using DRAMs generally have had to achieve their speed elsewhere.

In order to increase system speed, cache memory techniques have recently been applied to DRAM main memory. A cache memory is a high-speed buffer interposed between the processor and the main memory.

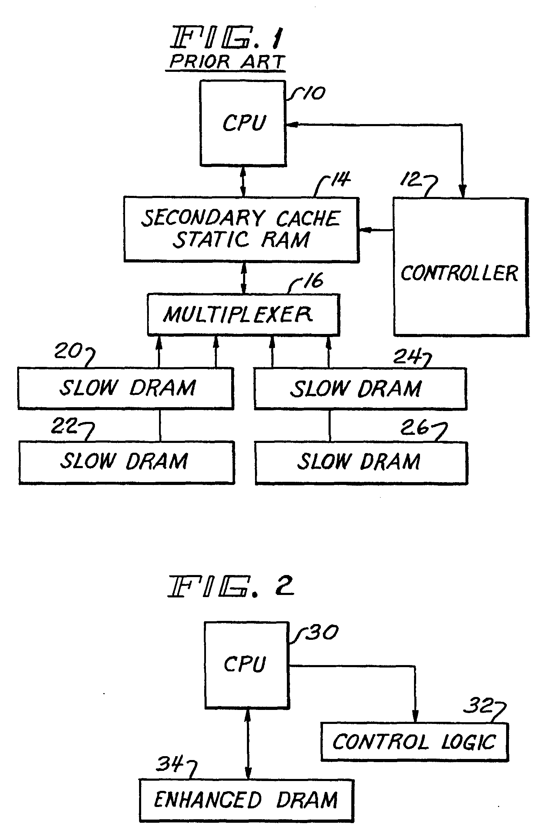

Fig. 1 indicates a prior art configuration wherein a processor 10 is configured with a cache controller 12 and a cache memory 14. The cache memory's main purpose is to maintain frequently accessed data for high speed system access. Cache memory 14 (sometimes called "secondary cache static RAM") is loaded via a multiplexer 16 from DRAMs 20, 22, 24 and 26. Subsequently, data is accessed at high speeds if stored in cache memory 14. If not, DRAMs 20, 22, 24 and/or 26 load the sought data into cache memory 14. As seen in Fig. 1, cache memory 14 may comprise a SRAM, which is generally faster than DRAMS 20-26.

Various approaches have been proposed for cache memory implementation. These approaches include controlling external cache memory by a controller, such as cache memory 14 and cache controller 12 in Fig. 1, or discrete proprietary logic.

Notwithstanding its benefits, cache memory techniques complicate another major problem that exists in system design. Memory components and microprocessors are typically manufactured by different companies. This requires the system designer to effectively bridge these elements, using such devices as the cache controller 12 and the multiplexer 16 of Fig. 1. The different pin configurations and timing requirements of these components makes interfacing them with other devices difficult. Adding a cache memory that is manufactured by a yet another company creates further design problems, especially since there is no standard for cache implementation.

Exacerbating the system design problems is the disadvantage that the use of external cache memory (such as cache memory 14) compromise the main storage access speed. There are mainly two reasons for this compromise. First, and most significant, the main storage access is withheld until a "cache miss" is realized. The penalty associated with this miss can represent up to two wait states for a 50 Mhz system. This is in addition to the time required for a main memory access. Second, the prioritized treatment of physical routing and buffers afforded the external cache is usually at the expense of the main memory data and address access path. As illustrated in Fig. 1, data from DRAMs 20, 22, 24 and 26 can be accessed only through cache memory 14. The actual delay may be small, but adds up quickly.

A third problem associated with separate cache and main memory is that the time for loading the cache memory from the main memory ("cache fill") is dependent on the number of inputs to the cache memory from the main memory. Since the number of inputs to the cache memory from the main memory is usually substantially less than the number of bits that the cache memory contains, the cache fill requires many clock cycles. This compromises the speed of the system.

A memory architecture that has been used or suggested for video RAMs ("VRAMs") is to integrate serial registers with a main memory. VRAMs are specific to video graphics applications. A VRAM may comprise a DRAM with high speed serial registers allowing an additional access port for a line of digital video data. The extra memory used here is known as a SAM (serially addressed memory), which is loaded using transfer cycles. The SAM's data is output by using a serial clock. Hence, access to the registers is serial, not random. Also, there is continuous access to the DRAM so refresh is not an issue as it is in other DRAM applications.

Another implementation that is expected to come to market in 1992 is an on-chip cache memory that will use a separate cache and cache controller sub-system on the chip. It uses full cache controllers and cache memory implemented in the same way as it would be if external to the chip, i.e. a system approach. This approach is rather complicated and requires a substantial increase in die size. Further, the loading time of the cache memory from the main memory is constrained by the use of input/output cache access ports that are substantially fewer in number than the number of cache memory cells. A cache fill in such a manner takes many clock cycles, whereby system access speed suffers. Such an approach is, in the inventors' views, somewhat cumbersome and less efficient that the present invention. As example of such an implementation is disclosed in Ward et al. U.S. Patent 4,894,770. Ward et al. discloses plural data buffers to receive and store rows of data.

Still another problem in system design is interleaving memory devices when used with external cache memory. Interleaving assigns successive memory locations to physically different memory devices, thereby increasing data access speed. Such interleaving is done for high-speed system memory access such as burst modes. The added circuitry for cache control and main memory multiplexing usually required by external cache memory creates design problems for effective interleaved memory devices.

Another problem with the prior art resides in the lack of memory system salability. Adding more memory would involve adding more external SRAM cache memory and more cache control logic. For example, to double the memory size in Fig. 1, not only are more DRAM devices required, but also another multiplexer and possibly another cache controller. This would obviously add to system power consumption, detract from system reliability, decrease system density, add manufacturing costs and complicate system design.

Another problem associated with system salability arises from manufacturing the system. When using external cache memory, manufacturers allocate a certain amount of board area for the main memory. Another, smaller area is allocated for the external cache. Usually, an increase in the main memory and the external cache memory while maintaining an acceptable cache hit probability is limited. This limitation arises from the dedication of more board area for the main memory than the external cache. Therefore, salability is limited when considering acceptable cache memory hit probability.

A further problem with system speed is the need for circuitry external to the main memory to write "post" data. Post data refers to data latched in a device until it is needed. This is done because the timing requirement of the component needing the data does not synchronize with the component or system latching the data. This circuitry usually causes timing delays for the component or system latching the data.

As stated supra, access to the DRAM memory cells during a precharge and refresh cycle was prohibited in the prior art. Some prior art approaches have tried to hide the refresh in order to allow access to DRAM data. One DRAM arrangement maintained the data output during a refresh cycle. The drawback of this arrangement was that the last read data was available only during the refresh. No new data read cycle could be executed during the refresh cycle.

A pseudo-static RAM is another arrangement that attempted to hide the refresh cycle. The device was capable of executing internal refresh cycles. However, any attempted data access during the refresh cycle would extend the data access time, in a worst case scenario, by a cycle time (refresh cycle time plus read access time). This arrangement did not allow true simultaneous access and refresh, but used a time division multiplexing scheme to hide the refresh cycle.

Another way to hide the refresh cycle is to interleave the RAM memory on the chip. When a RAM memory block with even addresses is accessed, the odd memory block is refreshed and vice-versa. This type of implementation requires more timing control restraints which translate to a penalty in access time.

Another type of problem arises when considering the type of access modes to the main memory. One type of access is page mode where the addresses are synchronously input into an array after a row address has been input. The output data access time will be determined from the timing clock edge (where the column address is valid) to the appearance of the data at the output. Another type is static column mode wherein the column addresses are input asynchronously. Access can occur in these modes only when RAS is active (low), and a prolonged time may be required in the prior art.

When manufacturing chips that support these access types, only one of these access types can be implemented into the device. Usually, one of the last steps in the making of the memory chip will determine if it will support either type of access. Thus, memory chips made this way do not offer both access modes. This induces an added expense in that the manufacturer must use two different processes to manufacture the two types of chips.

To overcome these problems, small modifications added to a component, such as a DRAM, may yield an increase in system performance and eliminate the need for any bridging components. To successfully integrate the modification with the component, however, its benefit must be relatively great or require a small amount of die space. For example, DRAM yields must be kept above 50% to be considered producible. Yields can be directly correlated to die size. Therefore, any modifications to a DRAM must take into account any die size changes.

In overcoming these problems, new DRAM designs have become significant. The greatest disadvantage to caching within DRAMs has been that DRAMs are too slow. The present invention seeks to change the architecture of the DRAM to take full advantage of high caching speed that may now be obtainable.

One way to meet this challenge is to integrate the functions of the main storage and cache. Embedding the cache memory within localized groups of DRAM cells would take advantage of the chip's layout. This placement reduces the amount of wire (conductive leads) used in the chip which in turn shortens data access times and reduces die size.

US 5,025,421 discloses a "single port dual RAM" comprising an array of DRAM memory cells and a set of SRAM storage cells. The DRAM cells and the SRAM cells are connected together by interface means comprising a plurality of MOS transistors. Data is read from and written to the DRAM cells by way of a single input/output port.

It is desirable to isolate the cache memory data access operation from undesirable DRAM timing overhead operations, such as refresh and precharge.

It is also desirable to eliminate the need for an external static RAM cache memory in high speed systems.

It is also desirable to insure cache/main memory data coherency.

The present invention provides an integrated circuit memory device as set out in claim 1. Accordingly, a high-speed memory device that is hybrid in its construction and is well-suited for use in high-speed processor-based systems can be provided. Preferably, tightly coupled row registers, are provided on the very same chip as the DRAM array(s). Preferably, the row registers are located within the DRAM array, and if the DRAM is configured with sub-arrays, then multiple SRAM row registers are provided for the multiple sub-arrays. Preferably the row registers are oriented parallel to DRAM rows (word lines), orthogonal to DRAM columns (bit lines). The row registers operate at high speed relative to the DRAM.

This integrated memory device preferably contains on-chip address compare circuitry, including a last read row address latch and an address comparator. Address and data latches, a refresh counter, and various logic for controlling the integrated memory device also are preferably included on the chip.

Memory reads preferably occur from the row registers. When an address is received by the memory device, the address comparator determines whether that address corresponds to an address of the row that was last read. When the address comparator detects a match ("hit"), only the row register is accessed and the data is available therefrom at SRAM speeds after the column address. Subsequent reads within the row (bursts reads, local instructions or data) will continue at that same high speed. When a read "miss" is detected, the DRAM main memory is addressed and the addressed data is written into the row register. In the event of a "miss," the data is available at the output at a slightly slower speed than a hit. Subsequent reads from the row register will have the same extremely fast access as for a hit.

Since the read is from the row register in both cases and the row register can be decoupled from the DRAM, the DRAM precharge can occur simultaneously and asynchronously without degrading performance. The refresh counter and an independent refresh bus are implemented to allow the main memory to be refreshed during row register reads.

Memory writes are preferably directed towards the main memory. When appropriate, the on-chip address comparator will also activate a simultaneous write to the row registers. The data in the row register and the data in the main memory will be coherent for the same address. Changing rows during memory writes, in a write "hit" situation, does not affect the contents of the row register unless the row address is the same as that of the row register. This allows the system to return immediately to the row register which had been accessed just prior to the write operation. Write posting can be executed without external data latches. Page mode memory writes can be accomplished within a single column address cycle time.

Without initiating a major read or write cycle, the row registers can be read under column address control. It is preferred that the chip is activated and the output is enabled.

The toggling of the on-chip address latch by the user allows an embodiment of the present invention to operate in either a page or static column mode. Further, the zero nano-second hold allows the /RE signal to be used to multiplex the row and column addresses.

When a read hit occurs on an /RE initiated cycle, the internal row enable signal is not enabled and a DRAM access does not occur, thereby shortening the cycle time and the precharge required.

It will be understood that a novel and important aspect of the operation of such a DRAM with embedded cache memory is the provision of zero-wait state data random accesses from the cache memory while the DRAM is being refreshed or precharged, or otherwise operated asynchronously.

Another feature is that within the array structure is embedded cache memory that allows quicker cache memory fill and optimization of die density.

A first method of operating the memory device may comprise the steps of: (1) initiating a major read or write cycle; (2) comparing the row address with the previous row address to determine whether the sought data is in the cache memory; (3) if in a read cycle, reading the data from the cache memory if it is stored there or loading the data into the cache memory from the main memory and then reading the data from the cache memory; and (4) if in a write cycle, writing only to the main memory if the data is not in the cache memory or writing to both main memory and cache memory if the data is in the cache memory.

A second method for operating the memory device may comprise the steps of: (1) refreshing a row of main memory; and (2) simultaneously and asynchronously reading the cache memory.

The invention, together with its objects and the advantages thereof, may best be understood by reference to the following detailed description taken in conjunction with the accompanying drawings of which:
Fig. 1 is a block diagram of the prior art cache implementation;
Fig. 2 is a block diagram of a circuit embodying the present invention;
Fig. 3 is a schematic block diagram of a memory device according to an embodiment of the present invention; and
Fig. 4 is a detailed diagram of a row address circuit;
Fig. 5 is a detailed diagram of a column address control circuit; and
Fig. 6 is a detailed diagram part of a row register and a memory array/row register interface.

Fig. 2 is a block diagram of the preferred embodiment of the present invention. A CPU 30 is preferably connected to both control logic circuitry 32 and an EDRAM 34. As can be seen in comparison with FIG. 1, the preferred embodiment of Fig. 2 uses only three chips as compared to the eight chips of Fig. 1. This Fig. 2 arrangement provides greater system performance, lower system cost, lower system power requirement, increased system reliability, improved system density, simplified system design and easy memory system salability.

Together with external control logic contained in control logic 32, EDRAM 34 of Fig. 2 supplants secondary cache 14, cache controller 12, multiplexer 16 and slow DRAMs 20, 22, 24 and 26 of Fig. 1. The total memory capacity of the four slow DRAM chips 20, 22, 24 and 26 can be combined onto one chip without the need for interleaving, thus eliminating the need for multiplexer 16. Further, EDRAM 34 preferably contains internal cache and cache control logic, thereby eliminating the need for secondary cache 14 and portions of cache logic 12.

With such integration of the various chip functions of the prior art, access to data in cache memory will have a zero wait-state. This fast access time will allow data transfer at high speeds (such as done in burst modes) without the need for interleaving or costly external cache memory. In addition, access to the EDRAM is preferably address sequence independent. This makes interleaving easier when used with address sequence dependent modes.

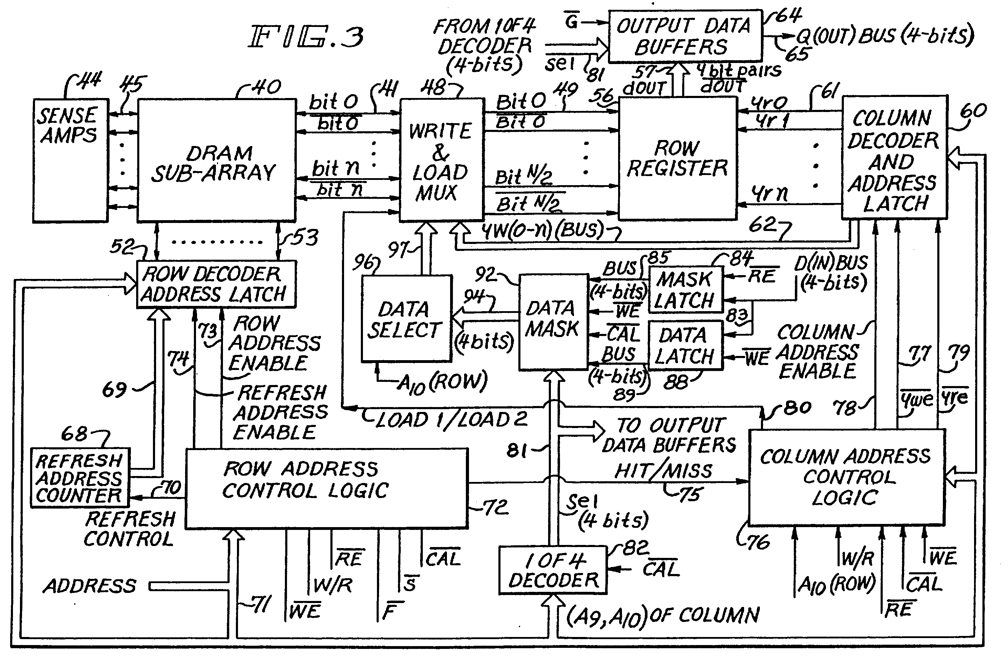

A more detailed description of EDRAM 34 will be discussed with reference to Fig. 3. EDRAM 34 preferably receives the following input signals:

| | |
|---|---|
| chip select signal | /S |
| refresh signal | /F |
| write/read signal | W/R |
| row enable signal | /RE |
| output signal | /G |
| data signal | D |
| write enable signal | /WE |
| address data | A₀-A₁₀ |
| column address latch signal | /CAL. |

An output Q is provided, illustratively four bits wide.

By way of major components, the circuit of Fig. 3 comprises a DRAM sub-array 40. Associated therewith are sense amplifiers 44 coupled to the sub-array via leads 45. From sub-array 40, a plurality of leads 41 couple data bits to a write and load multiplexer 48, which has output leads 49.

Fig. 3 also shows a row decoder/address latch 52 which is coupled via a plurality of leads 53 to DRAM sub-array 40.

A row register 56 is part of the circuit of Fig. 3. It receives signals from write and load multiplexer 48 via leads 49. Row register 56 is further coupled to receive signals from a column decoder 60 via a plurality of leads 61. Row register 56 outputs signals on leads 57 to output data buffers 64, which provide the output bus 65 of the circuit.

A refresh address counter 68 provides a plurality of signals on a bus 69 to row decoder and address latch 52. Counter 68 receives a refresh control signal via a lead 70 from row address control logic.

An address bus 71 is coupled to several blocks within Fig. 3, including row decoder 52, row address control logic 72, the column decoder 60, and further circuits discussed infra. Address bus 71 illustratively receives eleven bits of address data A₀-A₁₀. This address data preferably includes 11 bits of row data and then 11 further bits of column data, or vice-versa. Alternatively but not preferably, the bus could carry a smaller number of bits of both a row and a column addresses simultaneously. Another alternative, but not preferred, is that there may be two separate address buses: one for row addresses only and the other for column addresses only.

Address data on bus 71 is also applied to a column address control logic 76. A one-of-four decoder 82 preferably receives address data bits A₉ and A₁₀ from bus 71, and column address latch signal /CAL. Bus 71 is preferably multiplexed so that it carries row addresses and column addresses at respective times. Column address latch signal /CAL, chip select signal /S, refresh signal /F, row enable signal /RE, write/read signal W/R, and write enable signal /WE are connected to a row address control logic 72.

Row decoder 52 preferably receives as other inputs a row address enable and a refresh address enable output from row address control logic 72. Row address enable and refresh address enable are conducted on lines 73 and 74, respectively. Row decoder 52 is coupled to memory array 40, such as to its word lines, as is well-known. The word lines (not illustrated) are preferably orthogonal to columns (bit lines) in memory array 40, which may or may not contain sub-arrays.

As further seen in Fig. 3, memory array 40 is preferably coupled via lines 45 to sense amplifiers 44, as well-known in the art, and write and load multiplexer 48. Multiplexer 48 is preferably coupled to row register 56, which is preferably located on the opposite ends of the bit lines 41 to sense amplifiers 44.

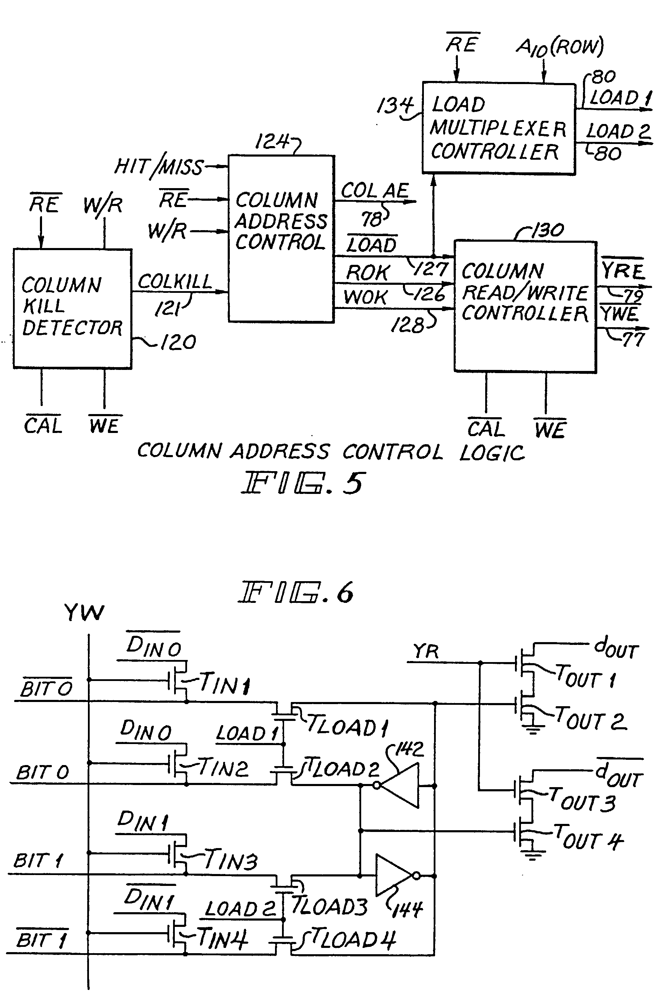

Preferably embedding row register 56 at the ends of the bit line pairs (not shown) of sub-array 40 minimally increases the die size of the preferred embodiment. Further, as illustrated in Fig. 6, two bit line pairs bit0 and /bit0, and bit1 and /bit1 are coupled to cross-coupled inverters 142 and 144 of row register 56. It will be appreciated that such cross-coupled inverters comprise a static flip-flop usable as a static memory cell. This circuit facilitates the extremely fast row register 56 fill since each of the inverter pairs, illustratively inverters 142 and 144, are selectively coupled to preferably two bit line pairs.

Preferably embedding the row register 56 and sense amplifiers 44 on respective opposing ends of the DRAM array (or sub-array) takes advantage of the impedance of the bit line pairs. This impedance helps maintain the state of sense amplifiers 44 when an unaltered write operation is performed. An unaltered write operation is where a memory bit or bits are written with a common mode high level voltage. This voltage on the bit line(s) will not cause the sense amplifiers 44 to toggle. Therefore, when the common mode high level voltage is removed from the intended unaltered bit line(s), the sense amplifier will restore the bit line(s) to the prior state.

It will be understood that the symbol "Y" connotes a column or column signal, of which there are several types (write, write enable, read, read enable). Multiplexer 48 is preferably coupled to receive write enable signals Yw from column decoder 60. Row register 56 preferably has as inputs column read signals Yr transmitted on lines 61 from column decoder 60. Row register 56 outputs Dₒᵤₜ via bus 57 to output data buffer 64. Buffer 64 also preferably receives the output enable signal /G and select bus 81 as inputs. Buffers 64 preferably outputs the output data Q on bus 65. Bus 65 is preferably 4-bits wide.

Column address control 76 preferably further receives as an input a hit/miss signal transmitted on line 75 from row address control logic 72. Control logic 76, as illustrated, outputs a loadl/load2 signal to multiplexer 48 via bus 80. Control logic 76 also preferably outputs a column read enable /Yre, column write enable /Ywe and column address decode enable to decoder 60 by way of lines 79, 77 and 78, respectively. Inputs to column address control 76 also preferably include write enable signal /WE, column address latch signal /CAL, row enable signal /RE, write/read signal W/R and address bit A₁₀ preferably of row address data.

Input data D conducted on bus 83 is illustratively input to both mask latch 84 and data latch 88. Bus 83 is preferably, but not limited to, a 4-bit width. Latch 84 preferably has /RE as an input latch enable. Latch 88 preferably has write enable /WE as an input latch enable. The outputs of both latches 84 and 88 are preferably coupled to data mask 92 along with write enable /WE and column address latch signal /CAL. As shown in Fig. 3, data mask 92 is also coupled to receive the output of decoder 82 via bus 81. Bus 81 is preferably 4-bits wide. The output of data mask 92 is coupled to data select circuit 96 through bus 94. Bus 94 is also preferred to be 4-bits wide. Select circuit 96 is preferably coupled through bus 97, preferably 4-bits wide, to multiplexer 48.

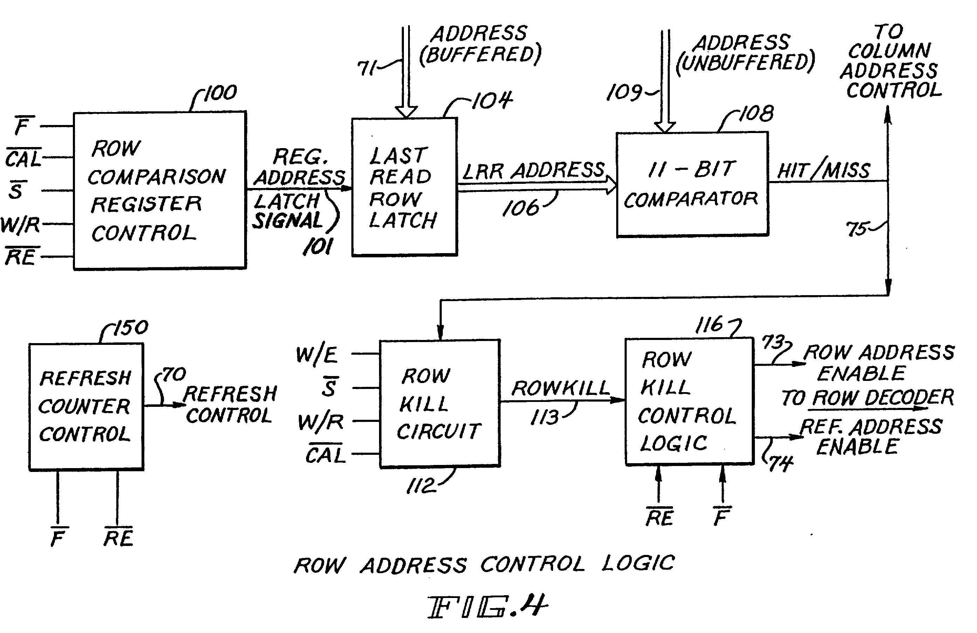

Referring now to Fig. 4, a last read row latch control 100 is preferably coupled to receive as inputs refresh signal /F, column address latch signal /CAL, chip select /S, write/read signal W/R and row enable /RE. The output of latch control 100 is illustratively connected to a last read row latch 104. Latch 104 also preferably receives row address data from bus 71. The output of latch 104 is preferably provided via a bus 106 to a comparator 108. Comparator 108 preferably compares two 11-bit address inputs, one of which is provided by latch 104. The other 11-bit address input is received preferably through a bus 109. The hit/miss signal output of comparator 108 is transmitted via line 75 to a row kill circuit 112 and column address control 76.

Row kill circuit 112 preferably receives as inputs write enable signal W/E, chip select /S, write/read signal W/R and column address latch signal /CAL. It checks the inputs to determine whether a valid read or write cycle has been initiated. If no such valid cycle has been initiated, it aborts and provides a row kill output signal to a row kill control logic circuit 116 by way of a line 113.

In addition to the row kill signal, control logic 116 preferably is coupled to receive row enable signal /RE and refresh signal /F. Control logic circuit 116 determines from these inputs whether it should enable the row decoder 52 (Fig. 3) to latch either the refresh address from refresh counter 68 or the row address from address bus 71.

Generally, row enable signal /RE when active signifies that there is a read or write access for the DRAM array 40. Refresh signal /F is active, it signifies that array 40 is to be refreshed, so row decoder 52 must latch row refresh address data. However, if the row kill signal is active, then the two outputs from control logic 116 will be inactive, which keeps the row decoder 52 from latching any address. Since no row is latched or decoded, the memory array 40 is not accessed and there is no destructive read, and no need to initiate precharge or refresh. The outputs "row address enable" and "refresh address enable" of control logic 116 are coupled via lines 73 and 74, respectively, to row decoder 52.

Fig. 5 preferably includes a column kill detector circuit 120 which preferably receives the following input signals: row enable /RE, write/read signal W/R, column address latch signal /CAL and write enable /WE. Detector 120 is preferably coupled to provide its output to a column address control circuit 124 and operates in a manner similar to row kill circuit 112. It detects whether a valid column address is received.

Control circuit 124 also preferably receives the following input signals: "hit/miss", write/read W/R, row enable /RE and column kill. From these inputs, control 124 determines whether a column read or column write is to occur. It generates four outputs, of which ROK ("read OK"), /LOAD (ENABLE), and WOK ("write OK") are coupled to a column read/write controller 130 by way of lines 126, 127 and 128 as shown in Figure 5. Further, it is preferred that line 127 is also connected to a load multiplexer controller 134. A fourth output (column address enable) of controller 124 is output over line 78 to column decoder 60.

Column read/write controller 130 also receives as further inputs write enable /WE and /CAL. Controller 130 also preferably output /Yre and /Ywe through lines 79 and 77, respectively, to column decoder 60.

Load multiplexer controller 134 preferably receives as inputs address bit A₁₀ and /RE. The outputs of controller 134, loadl and load2, are illustratively coupled to multiplexer 48 via lines 80.

Referring now to Fig. 6, field effect transistors are shown for illustrative purposes. Other types cf transistors or switching devices may be employed. In Fig. 6, a first pair of complementary bit lines BIT0 and /BIT0, and a second such pair BIT1 and /BIT1 are coupled to memory array 40 (not shown) of Fig. 3 and to one side of the source-drain paths of write transistors Tᵢₙ₂, Tᵢₙ₁, Tᵢₙ₃ and Tᵢₙ₄, respectively. The other sides of the source-drain paths of transistors Tᵢₙ₁, Tᵢₙ₂, Tᵢₙ₃ and Tᵢₙ₄ are coupled to a select circuit output bus 97. Bus 97 is illustratively composed of Dᵢₙ₀, /Dᵢₙ₀, Dᵢₙ₁ and /Dᵢₙ₁. The gate electrodes of transistors Tᵢₙ₁, Tᵢₙ₁, Tᵢₙ₃ and Tᵢₙ₄ are coupled to Yw bus 62.

The bit lines are selectively coupled by field effect transistors or other switching devices to the latches of the row register, whereby they may be selectively decoupled. Thus, bit line pairs BITO and /BITO, and BIT1 and /BIT1, the bit lines representing columns of the DRAM array, are also preferably coupled to the nearer side of the source-drain paths of T_{load1}, T_{load2}, T_{load3} and T_{load4}. Preferably, the gate electrodes of T_{load2} and T_{load1} are coupled together, as are the gate electrodes of T_{load3} and T_{load4}. The source-drain paths at the sides of T_{load1} and T_{load4} more remote from the DRAM array in Fig. 6 are coupled to the input of inverter 142, the output of inverter 144, to each other and to the gate electrode of Tₒᵤₜ₂. The similarly-situated electrodes of T_{load2} and T_{load3} are coupled to the output of inverter 142, the input of inverter 144, to each other and to the gate electrode of Tₒᵤₜ₄.

The source-drain paths of each of Tₒᵤₜ₂ and Tₒᵤₜ₄ are coupled to ground potential. The other respective source-drain electrodes of Tₒᵤₜ₂ and Tₒᵤₜ₄ are respectively coupled to respective electrodes of Tₒᵤₜ₁ and Tₒᵤₜ₃. The gates of Tₒᵤₜ₁ and Tₒᵤₜ₃ are connected to each other and to line 61, which preferably conducts Yr. The other respective electrodes of Tₒᵤₜ₁ and Tₒᵤₜ₃ are respectively coupled to bus 57.

A fuller description of the operation of the preferred embodiment will now be described. It is preferred that row enable signal /RE be the main selection input signal. When row enable signal /RE is asserted while chip select signal /S is low, all on-chip circuitry is preferably activated. When chip select signal /S is high, EDRAM 34 is in a preferred standby mode. However, a /F refresh may be performed while the chip is in a standby mode.

In order to realize the speed gains of the present invention, it is preferred that a look-ahead method be used for a row address comparison step. This is done to eliminate time delays caused by access cycles initiated before the comparison. Look-ahead requires a positive row address set-up time. The actual comparison between the previous row address and the present row address is done during a short set-up period. This preferably results in comparator 108 being able to determine close to the falling edge of row enable signal /RE if an address hit (match) has occurred. If the addresses are buffered before they are input to EDRAM 34, it is preferred that the present address to be compared to the last read row address be unbuffered. When addresses are present on chip, conventional buffering is used. But the comparator path in the preferred embodiment takes its signal directly, without buffering, from the address pins. This approach allows for the high speed address comparison before row enable /RE transitions from high to low.

Address multiplexed DRAMs usually have an zero nanosecond set-up time and a finite hold time. The preferred embodiment herein described preferably has a zero nanosecond hold time. Implementing a row enable signal /RE with a zero nanosecond hold time allows that signal to be preferably used as an address multiplexer signal. It is preferred that the user or system also compare the addresses in order that it knows the exact time that data will be present from the EDRAM.

Referring to Fig. 3, row address control 72 receives bus 71, write enable /WE, write/read signal W/R, row enable /RE, refresh signal /F, chip select /S and column address latch signal /CAL. These inputs are internally coupled in row address control 72 as shown in Fig. 4. Latch control 100 will provide an enabling signal to latch 104 only if there is a valid read cycle initiated. Preferably, latch control 100 will provide this signal if refresh signal /F and column address latch signal /CAL are high, and chip select signal /S and write/read signal W/R are low when row enable signal /RE transitions from high to low. This enable conducted on line 101 allows latch 104 to latch the last read row address, which is preferably input via bus 71. It is preferred that the latching of the last row address occur when there is a valid read cycle.

Latch 104 preferably outputs the latched address to comparator 108. Comparator 108 preferably compares the last read row address provided by latch 104 to the unbuffered present address input by way of bus 109. The state of signal hit/miss output from comparator 108 will depend preferably on the equality of the compared address.

The signal hit/miss is supplied through line 75 to row kill circuit 112. If the input signals write enable /WE, chip select /S, write/read W/R, and column address latch /CAL are not a valid input combination, or hit/miss signal is active, line 113 will make inactive row kill control logic 116, regardless of the states of the other inputs. However, lines 73 or 74 will be active depending on the states of row enable /RE and refresh /F and the inactive state of line 113. Lines 73 and 74 are supplied to decoder 52 of Fig. 3 preferably to control which, if any, address is latched into the row decoder.

Preferably, to refresh memory array 58, refresh signal /F is polled on the assertion of row enable signal /RE. When refresh signal /F is detected by the falling edge of row enable signal /RE as low, an internal refresh cycle is preferably executed. Refresh counter 68 supplies the row address field to decoder 52. Refresh counter 68 is preferably incremented at the end of the row enable signal /RE cycle in preparation for the next refreshing signal /F type refresh cycle. It is preferred that all binary combinations of address A₀-A₁₀ must be refreshed every 16 milliseconds. Also, an address bit A₁₀ preferably does not have to be cycled, but must remain valid during row address setup and hold times.

As illustrated in Fig. 4, refresh signal generator 150 preferably has as inputs refresh /F and row enable /RE. It is preferred that refresh signal /F be active when row enable /RE transitions from high to low. The output of generator 150, if active, will be provided to increment counter 68 of Fig. 3 when the device is performing a row refresh. The value of counter 68 will preferably be continually supplied to decoder 52.

Decoder 52 will latch and decode either the refresh address supplied by line 69 or the present row address supplied by bus 71, depending on the states of lines 73 and 74. Decoder 52 and sense amplifiers 44 communicate with sub-array 40 as well known in the art to either input or output bit values on lines 41.

As illustrated in Fig. 6, the different access cycles will be now be explained. Preferably, when there is a hit on a read cycle, load signals Load1 and Load2 are not active. This causes load transistors Tload1, Tload2, Tload3 and Tload4 to be off, thereby decoupling inverters 142 and 144 from bit pair line bit0 and /bit0, and bit1 and /bit1. Shown in Fig. 6 are two bit line pairs provided by lines 41 and coupled to inverters 142 and 144. The scope of this invention is not limited to the ratio of two bit line pairs to one pair of inverters.

Column write address signal Yw remains inactive which maintains input transistors Tin1, Tin2, Tin3 and Tin4 off. Thus the sub-array 40 (not shown) is isolated from the read. This isolation does not cause sub-array 40 to destructively discharge, hence another access to sub-array may occur quicker than if an access had occurred. Column read address signal Yr is active, which preferably activates Toutl and Tout3 such that data at the gates will be an inverted output on lines dout and /dout. A write to the sub-array may occur when inverters 142 and 144 are decoupled and being read.

In the case where there is a read with a miss, then the load transistors Tload1, Tload2 or Tload3 and Tload4 are turned on by load signal Load1 or Load2 being active. This will transfer data provided on either bit line pairs of lines 41 to the inverter pairs 142 and 144. The read cycle then preferably proceeds as above.

For a write cycle with a miss, load signals Load1 and Load2 preferably do not turn on load transistor Tload1, Tload2, Tload3 and Tload4. Instead, column write enable signal Yw turns on input transistors Tin1, Tin2, Tin3 and Tin4. This causes data on supplied by bus 97 to be input to sub-array 40. As this write occurs, reads of the decoupled inverters 142 and 144 may occur.

When a write cycle with a hit is determined, the steps for the write miss described supra are the same except that load signals Load1 or Load2 turn on load transistors Tload1, Tload2 or Tload3 and Tload4. The data provided on bus 97 will then be written to both sub-array 40 and inverters 142 and 144. The reading of the inverters 142 and 144 may be done during this cycle.

When the user determines that the data to be read is maintained by inverters 142 and 144, a read of those inverters can be accomplished without initiating a row enable /RE type cycle. The user, as will be explained infra, must activate chip select signal /S, output enable signal /G and must present valid column addresses. In this manner, the data maintained on inverters 142 and 144 can be read by simply activating the output transistors Toutl and Tout3 with column read address signal Yr.

Further, as this non-/RE type cycle proceeds, it is preferred that the sub-array may be simultaneously and asynchronously accessed while the DRAM is performing a /F-type refresh or during the time that the DRAM is in precharge following read/write cycles. This is possible since the load transistors Tload1, Tload2, Tload3 and Tload4 are not active, which decouples inverters 142 and 144 from the bit line pairs of lines 41.

Referring now to Fig. 3, when data is provided on lines 57 (illustratively 2 bit pairs wide per register), buffer 64 will be enabled by bus 81 and output enable signal /G. Data will then be supplied to bus 65 (illustratively 4 bits wide). Buffer 64 can also preferably post the output data.

Referring now to column address control logic 76 of Fig. 3, a more detailed description of its preferred operation will be explained with reference to Fig. 5. Column kill detector 120 will be active when the states of inputs row enable /RE, write/read signal W/R, column address latch signal /CAL and write enable /WE are an invalid write cycle. The signal generated by detector 120 will ultimately disable the operation of column decoder 60 of Fig. 3.

Column address control 124 generates a read enable signal on line 126, a column latch enable on line 78, a load enable signal on line 127 and a write enable signal on line 128. The generation of these signals is preferably responsive to the states of inputs hit/miss, write/read W/R and the output of detector 120 when row enable /RE transitions. It should be known that toggling input /CAL to detector 120 will cause the column address enable signal on line 78 to toggle. Toggling line 78 enables the latch (not shown) in column decoder 60 of Fig. 3. Enabling this latch will allow for fast page mode or static column mode access to row register 56 of Fig. 3. Operation in a static column mode can continue into the next row enable signal /RE cycle with no access time penalty if the row address remains the same as the previous cycle.

The data latching also releases the system's need to persist with the holding of the data, thus eliminating the system's need for external write data post latch circuitry. Further, data latching in conjunction with the decoupling of the cache memory allows for many write/read situations to achieve continual zero wait-state operations for, as an example, an odd/even word interleave arrangement. Once input data is latched in latch 88, the device can ignore the logic state of the data-in pin D. This permits subsequent access to the cache contents concurrent with the internal, physical write.

The use of column address latch signal /CAL during the write cycles allows early posting of input data, latched by write enable signal /WE, prior to the presence of a valid column address. This eliminates the need for external write posting by the system. Any subsequent writes must have another column address input. Controller 130 generates outputs on lines 77 and 79 that enable the column decoder 60 of Fig. 3 to either provide a read or write column address to the circuitry in Fig. 6. Lines 77 and 79 will be active if input lines 126 or 128 are active, which are controlled by write/read signal W/R, and inputs /CAL and /WE are active.

Line 127 output from controller 124 enables controller 134 to generate signals Load1 or Load2, which are provided to multiplexer 48 of Fig. 4. Load1 or Load2 are determined by the state of input A₁₀ when /RE transitions.

Referring now to Fig. 3, decoder 60 will latch the address provided by bus 71 if line 78 is active, which address will be subsequently decoded. Decoder 60 will provide active signals conducted by lines 61 to row register 56 if line 79 is active, which reflects a memory read. Preferably, decoder 60 will provide active signals on lines 62 to multiplexer 48 if line 77 is active, which reflects a memory write.

Referring now to the data-in path, input data on bus 83 is supplied to mask latch 84 and data latch 88. Bus 83 is preferably four bits wide. Latch 84 will capture the mask input data when /RE transitions. Mask input data is used when the user requires that less than the four addressed memory bits are to be written. Latch 88 will capture the input data when /WE becomes active. The outputs of latches 84 and 88 are input, along with /CAL and /WE to data mask circuit 92. Circuit 92 also receives bus 81, preferably four bits wide. Circuit 92 will output the data from latch 88 that is not masked by latch 84. The bits that are masked are output to data select circuit 96 in a predetermined state.

When the device is used as a 1-bit wide memory, decoder 82 will output a select signal on bus 81, preferably determined by row address bits A₉ and A₁₀. Mask circuit 92 will then output the selected bit determined by the state of bus 81. Of the four input bits provided by bus 94, two will be selected based preferably on the state of row address A₁₀. Preferably, these selected and unselected bits will be output to multiplexer 48.

In the case where the row and column addresses are not multiplexed, the row and column addressed can be presented at the same time. Access time for a /RE read access where a hit occurs can have the same access as a row register access where /RE has not been asserted. With /RE internally terminated on a hit, the row register 56 is not coupled to DRAM 40 and can be accessed as soon as a column address is available.

Numerous modifications or alterations can be made. For example, instead of multiplexing two bits on the same storage cell of row register 56, as shown in fig. 6, each bit line pair in output from DRAM sub array 40 may be coupled to a dedicated storage cell in which case, the row register 56, rather than storing half the number of bits which may be simultaneously read out from DRAM sub array 40 (half row), will store the full row.

## Claims

1. An integrated circuit memory device comprising:
an array (40) of DRAM memory cells, the array including a plurality of bit lines;
a set of registers (142, 144) usable as cache memory;
a coupling circuit (T_{LOAD1} - T_{LOAD4}) selectively coupling said registers to said array;
characterised in that the device further comprises:
a read port (T_{OUT1} - T_{OUT4}) coupled to said set of registers for reading data from the memory array and from the registers; and
a separate write port (T_{IN1} -T_{IN4}) for writing data to the memory array.

2. The memory device of Claim 1 wherein said coupling circuit includes coupling transistors (T_{LOAD1} - T_{LOAD4}) connected between said bit lines and said registers, wherein each of said coupling transistors has a respective control electrode.

3. The memory device of Claim 2 wherein each said control electrode is coupled for receiving a corresponding control signal (LOAD1, LOAD2) to be commonly applied to at least two of said control electrodes.

4. The memory device of Claim 3 wherein said control electrodes of said coupling transistors are coupled for receiving at least two control signals, wherein some of said control electrodes are coupled to receive a first one of said control signals (LOAD 1) and some other ones of said control electrodes are coupled to receive a second one of said control signals (LOAD 2).

5. The memory device of Claim 4 wherein:
two of said coupling transistor control electrodes are coupled to receive said first control signal (LOAD 1); and
two other ones of said coupling transistor control electrodes are coupled for receiving said second control signal (LOAD 2).

6. The memory device of Claim 2 wherein each said coupling transistor further includes first and second electrodes;
wherein said first electrodes are coupled to said bit lines;
wherein said read port includes read port transistors (T_{OUT1} - T_{OUT4}); and
wherein some of said second electrodes of said coupling transistors are coupled to a corresponding read port transistor.

7. The memory device of Claim 6 wherein said coupling transistor second electrodes that are coupled to said read port transistors are coupled to gate electrodes of said read port transistors, thereby providing a high impedance read port.

8. The memory device of Claim 6 wherein said some second electrodes of said coupling transistors are also coupled to a first terminal of a corresponding one of said registers (142, 144).

9. The memory device of Claim 8 wherein other ones of said second electrodes of said coupling transistors bit lines and said registers are connected to a second terminal of the corresponding one of said registers (142, 144).

10. The memory device of Claim 6 wherein said second electrodes of said coupling transistors are coupled to first and second terminals of said registers.

11. The memory device of Claim 2 wherein said write port comprises a plurality of input transistors (T_{IN1} - T_{IN4}), each having first, second, and control electrodes;
wherein each said input transistor first electrode is coupled to a respective bit line.

12. The memory of Claim 11 wherein each said input transistor second electrode is coupled to receive a data input bit (DIN0, DIN1) or a complement thereof; and each said control electrode of said input transistors is coupled to receive a column decode signal.

13. The memory device of Claim 1 wherein said coupling circuit, read port, write port, and registers comprise:
a plurality of cross-coupled inverters (142, 144) forming said registers, each said register having a first terminal and a second terminal;
a plurality of coupling transistors (T_{LOAD1} - T_{LOAD4}) each having first, second, and control electrodes, said second electrodes being connected to selected ones of said first and second terminals of said registers;
a plurality of read port transistors (T_{OUT1} - T_{OUT4}), each having a respective control electrode;
wherein each said second electrode of the coupling transistors is coupled also to a corresponding one of said read port transistors;
wherein each said coupling transistor control electrode is connected to at least one other coupling transistor control electrode and coupled to receive a corresponding one of a plurality of control signals (LOAD 1, LOAD 2);
a plurality of write port transistors (T_{IN1} - T_{IN4}) connected to respective ones of said bit lines (45) and coupled to receive write data, said write port transistors being located so that said write data can be applied to the bit lines regardless of the state of the coupling transistors.

14. The memory device of Claim 13 wherein said coupling transistor second electrodes are coupled to said control electrodes of said read port transistors, thereby providing a high impedance read port.

15. The memory device of Claim 1 wherein said read port is unidirectional and said write port is unidirectional.

16. The memory device of Claim 1 further comprising a column address decoder (60) coupled to said read ports and said write ports.

17. The memory device of Claim 1 wherein said array is arranged as a plurality of DRAM subarrays each having a respective plurality of bit lines;
wherein said set of row registers is arranged as a plurality of sets of row registers corresponding in number to said plurality of DRAM subarrays; and
wherein each said subarray is coupled to store read data in only one respective set of row registers, and each set of row registers is coupled to receive and store read data from only one corresponding DRAM subarray.

18. The memory device of Claim 17 wherein each said DRAM subarray is positioned between its respective set of row registers (56) and the sense amplifiers (44) corresponding to said subarray.

## Patentansprüche

1. Integrierter Speicherschaltkreis mit
einem Feld (40) von DRAM Speicherzellen mit mehreren Bitleitungen,
einem Satz von als Cache-Speicher verwendbaren Registern (142, 144),
einer Koppelschaltung (T_{LOAD 1} bis T_{LOAD 4}), die wahlweise die Register mit dem Feld verbindet,
**gekennzeichnet durch**
einen Schreibport (T_{OUT 1} bis T_{OUT 4}), der Daten aus dem Speicherfeld und aus den Registern liest und mit dem Satz von Registern gekoppelt ist, und
einen abgetrennten Schreibport (T_{IN 1} bis T_{IN 2}) zum Schreiben von Daten in das Speicherfeld.

2. Speicherschaltkreis nach Anspruch 1, dadurch gekennzeichnet, daß die Koppelschaltung zwischen die Bitleitungen und die Register geschaltete Koppeltransistoren (T_{LOAD 1} bis T_{LOAD 4}) enthält, die jeweils eine entsprechende Steuerelektrode besitzen.

3. Speicherschaltkreis nach Anspruch 2, dadurch gekennzeichnet, daß jede Steuerelektrode derart gekoppelt ist, daß ein entsprechendes Steuersignal (LOAD 1, LOAD 2), das gemeinsam an mindestens zwei Steuerelektroden angelegt wird, empfangen werden kann.

4. Speicherschaltkreis nach Anspruch 3, dadurch gekennzeichnet, daß die Steuerelektroden der Koppeltransistoren zum Empfang mindestens zweier Steuersignale gekoppelt sind, wobei einige der Steuerelektroden ein erstes Steuersignal (LOAD 1) und einige andere ein zweites Steuersignal (LOAD 2) empfangen.

5. Speicherschaltkreis nach Anspruch 4, dadurch gekennzeichnet, daß
zwei der Steuerelektroden der Kopplungstransistoren zum Empfang des ersten Steuersignals (LOAD 1) gekoppelt sind, und daß
zwei andere Steuerelektroden der Kopplungstransistoren zum Empfang des zweiten Steuersignals (LOAD 2) gekoppelt sind.

6. Speicherschaltkreis nach Anspruch 2, dadurch gekennzeichnet, daß jeder Kopplungstransistor weiterhin erste und zweite Elektroden aufweist,
wobei die ersten Elektroden an die Bitleitungen gekoppelt sind,
wobei der Leseport Leseport-Transistoren (T_{OUT 1} bis T_{OUT} ₄) umfaßt, und
wobei einige der zweiten Elektroden der Kopplungstransistoren an einen entsprechenden Leseport-Transistor gekoppelt sind.

7. Speicherschaltkreis nach Anspruch 6, dadurch gekennzeichnet, daß die an die Leseport-Transistoren gekoppelten zweiten Elektroden der Kopplungstransistoren an Gate-Elektroden der Leseport-Transistoren gekoppelt sind, wodurch sie einen Leseport hoher Impedanz erzeugen.

8. Speicherschaltkreis nach Anspruch 6, dadurch gekennzeichnet, daß einige der zweiten Elektroden der Kopplungstransistoren auch an einem entsprechenden ersten Anschluß der Register (142, 144) gekoppelt sind.

9. Speicherschaltkreis nach Anspruch 8, dadurch gekennzeichnet, daß die anderen der zweiten Elektroden der Bitleitungen der Kopplungstransistoren und der Register an einen entsprechenden zweiten Anschluß der Register (142, 144) angeschlossen sind.

10. Speicherschaltkreis nach Anspruch 6, dadurch gekennzeichnet, daß die zweiten Elektroden der Kopplungstransistoren an die ersten und zweiten Anschlüsse der Register angeschlossen sind.

11. Speicherschaltkreis nach Anspruch 2, dadurch gekennzeichnet, daß der Schreibport mehrere Eingabetransistoren (T_{IN 1} bis T_{IN 4}) mit jeweils ersten, zweiten und Steuerelektroden aufweist,
wobei jede der ersten Elektroden der Eingabetransistoren an die entsprechende Bitleitung angeschlossen ist.

12. Speicher nach Anspruch 11, dadurch gekennzeichnet, daß jede zweite Elektrode der Eingabetransistoren zum Empfang eines Dateneingabebits (DIN 0, DIN 1) oder dessen Komplements gekoppelt ist, und daß jede Steuerelektrode der Eingabetransistoren zum Empfang eines Spaltendekodiersignals gekoppelt ist.

13. Speicherschaltkreis nach Anspruch 1, dadurch gekennzeichnet, daß die Koppelschaltung, der Leseport, der Schreibport und die Register folgendes aufweisen:
mehrere kreuzgekoppelte Inverter (142, 144), die die Register bilden, von denen jedes einen ersten und einen zweiten Anschluß besitzt,
mehrere Kopplungstransistoren (T_{LOAD 1} bis T_{LOAD 4}), von denen jeder erste, zweite und Steuerelektroden aufweist, wobei die zweiten Elektroden mit ausgewählten ersten und zweiten Anschlüssen der Register verbunden sind;
mehrere Leseport-Transistoren (T_{OUT 1} bis T_{OUT 4}), von denen jeder eine entsprechende Steuerelektrode besitzt,
wobei jede zweite Elektrode der Kopplungstransistoren auch an einen entsprechenden Leseport-Transitor gekoppelt ist,
wobei jede Steuerelektrode der Kopplungstransistoren mit mindestens einer anderen Steuerelektrode der Kopplungstransistoren verbunden ist und zum Empfang eines entsprechenden der vielen Steuersignale (LOAD 1, LOAD 2) gekoppelt ist, und
wobei mehrere Schreibport-Transistoren (T_{IN 1} bis T_{IN 4}) mit den entsprechenden Bitleitungen (45) verbunden sind und zum Empfang von Schreibdaten gekoppelt sind, wobei die Schreibport-Transistoren derart angeordnet sind, daß die Schreibdaten unabhängig vom Zustand der Kopplungstransistoren auf die Bitleitungen gegeben werden können.

14. Speicherschaltkreis nach Anspruch 13, dadurch gekennzeichnet, daß die zweiten Elektroden der Kopplungstransistoren an die Steuerelektroden der Leseport-Transistoren gekoppelt sind, wodurch ein Leseport hoher Impedanz erzeugt wird.

15. Speicherschaltkreis nach Anspruch 1, dadurch gekennzeichnet, daß der Leseport und der Schreibport unidirektional sind.

16. Speicherschaltkreis nach Anspruch 1 mit einem Spaltenadressendekoder (60), der an die Lese- und Schreibports gekoppelt ist.

17. Speicherschaltkreis nach Anspruch 1, dadurch gekennzeichnet, daß das Feld als eine Vielzahl von DRAM Unterfeldern mit jeweils einer entsprechenden Vielzahl von Bitleitungen ausgeführt ist,
daß der Satz von Zeilenregistern als eine Vielzahl von Sätzen von Zeilenregistern ausgeführt ist, deren Anzahl der Vielzahl der DRAM Unterfeldern entspricht, und
daß jedes Unterfeld zur Speicherung von Lesedaten in nur einem entsprechenden Satz von Zeilenregistern gekoppelt ist, und jeder Satz von Zeilenregistern zum Empfang und zur Speicherung von Lesedaten von nur einem entsprechenden DRAM Unterfeld gekoppelt ist.

18. Speicherschaltkreis nach Anspruch 17, dadurch gekennzeichnet, daß jedes DRAM Unterfeld zwischen seinem jeweiligen Satz von Zeilenregistern (56) und dem Unterfeld entsprechenden Leseverstärker (44) angeordnet ist.

## Revendications

1. Mémoire en circuit intégré comprenant:
un réseau (40) de cellules de mémoire DRAM, le réseau incluant une pluralité de lignes de bit;
un ensemble de registres (142, 144) utilisable comme antémémoire;
un circuit de couplage (T_{LOAD1} à T_{LOAD4}) couplant sélectivement lesdits registres audit réseau;
caractérisé en ce que le dispositif comprend également:
un port de lecture (T_{OUT1} à T_{OUT4}) couplé audit ensemble de registres pour lire des données dans le réseau de mémoire et dans les registres; et
un port d'écriture séparé (T_{IN1} à T_{IN4}) pour écrire des données dans le réseau de mémoire.

2. Mémoire selon la revendication 1, dans laquelle ledit circuit de couplage comprend des transistors de couplage (T_{LOAD1} à T_{LOAD4}) connectés entre lesdites lignes de bit et lesdits registres, dans laquelle chacun desdits transistors de couplage comprend une électrode de commande respective.

3. Mémoire selon la revendication 2, dans laquelle chaque dite électrode de commande est couplée pour recevoir un signal de commande correspondant (LOAD1, LOAD2) destiné à être appliqué à au moins deux desdites électrodes de commande en commun.

4. Mémoire selon la revendication 3, dans laquelle lesdites électrodes de commande desdits transistors de couplage sont couplées pour recevoir au moins deux signaux de commande, dans laquelle certaines desdites électrodes de commande sont couplées pour recevoir un premier desdits signaux de commande (LOAD 1) et quelques autres desdites électrodes de commande sont couplées pour recevoir un second desdits signaux de commande (LOAD 2).

5. Mémoire selon la revendication 4, dans laquelle:
deux desdites électrodes de commande de transistor de couplage sont couplées pour recevoir ledit premier signal de commande (LOAD 1); et
deux autres desdites électrodes de commande de transistor de couplage sont couplées pour recevoir ledit second signal de commande (LOAD 2).

6. Mémoire selon la revendication 2, dans laquelle chacun desdits transistors de couplage comprend également des première et seconde électrodes;
dans laquelle lesdites premières électrodes sont couplées auxdites lignes de bit;
dans laquelle ledit port de lecture inclut des transistors de port de lecture (T_{OUT1} à T_{OUT4}); et
dans laquelle certaines desdites secondes électrodes desdits transistors de couplage sont couplées à un transistor de port de lecture correspondant.

7. Mémoire selon la revendication 6, dans laquelle lesdites secondes électrodes de transistor de couplage qui sont couplées auxdits transistors de port de lecture sont couplées à des électrodes de porte desdits transistors de port de lecture, afin de fournir ainsi un port de lecture à haute impédance.

8. Mémoire selon la revendication 6, dans laquelle lesdites certaines secondes électrodes desdits transistors de couplage sont couplées aussi à une première borne d'un registre correspondant desdits registres (142, 144).

9. Mémoire selon la revendication 8, dans laquelle d'autres électrodes desdites secondes électrodes desdites lignes de bit de transistor de couplage et lesdits registres sont connectés à une seconde borne de celui correspondant desdits registres (142, 144).

10. Mémoire selon la revendication 6, dans laquelle lesdites secondes électrodes desdits transistors de couplage sont couplées à des première et seconde bornes desdits registres.

11. Mémoire selon la revendication 2, dans laquelle ledit port d'écriture comprend une pluralité de transistors d'entrée (T_{IN1} à T_{IN4}) ayant chacun une première, une seconde électrode, et une électrode de commande;
dans laquelle chaque dite première électrode de transistor d'entrée est couplée à une ligne de bit respective.

12. Mémoire selon la revendication 11, dans laquelle chaque dite seconde électrode de transistor d'entrée est couplée pour recevoir un bit d'entrée de données (D_{IN0}, D_{IN1}) ou un complément de celui-ci; et chaque dite électrode de commande desdits transistors d'entrée est couplée pour recevoir un signal de décodage de colonne.

13. Mémoire selon la revendication 1, dans laquelle lesdits circuit de couplage, port de lecture, port d'écriture, et registres comprennent:
une pluralité d'inverseurs rétrocouplés (142, 144) formant lesdits registres, chacun desdits registres ayant une première borne et une seconde borne;
une pluralité de transistors de couplage (T_{LOAD1} à T_{LOAD4}) ayant chacun une première, une seconde électrode, et une électrode de commande, lesdites secondes électrodes étant connectées à des bornes sélectionnées desdites première et seconde bornes desdits registres;
une pluralité de transistors de port de lecture (T_{OUT1} à T_{OUT4}) ayant chacun une électrode de commande respective;
dans laquelle chaque dite seconde électrode des transistors de couplage est couplée aussi à l'un correspondant desdits transistors de port de lecture;
dans laquelle chaque dite électrode de commande de transistor de couplage est connectée à au moins une autre électrode de commande de transistor de couplage et est couplée pour recevoir un signal correspondant d'une pluralité de signaux de commande (LOAD 1, LOAD 2);
une pluralité de transistors de port d'écriture (T_{IN1} à T_{IN4}) connectés à des lignes respectives desdites lignes de bit (45) et couplés pour recevoir des données d'écriture, lesdits transistors de port d'écriture étant placés de façon que lesdites données d'écriture peuvent être appliquées aux lignes de bit indépendamment de l'état des transistors de couplage.

14. Mémoire selon la revendication 13, dans laquelle lesdites secondes électrodes de transistor de couplage sont couplées auxdites électrodes de commande desdits transistors de port de lecture, afin de fournir ainsi un port de lecture à haute impédance.

15. Mémoire selon la revendication 1, dans laquelle ledit port de lecture est unidirectionnel et ledit port d'écriture est unidirectionnel.

16. Mémoire selon la revendication 1, comprenant également un décodeur d'adresses de colonne (60) couplé auxdits ports de lecture et auxdits ports d'écriture.

17. Mémoire selon la revendication 1, dans laquelle ledit réseau est prévu sous la forme d'une pluralité de sous-réseaux DRAM ayant chacun une pluralité respective de lignes de bit;
dans laquelle ledit ensemble de registres de rangée est prévu sous la forme d'une pluralité d'ensembles de registres de rangée correspondant en nombre à ladite pluralité de sous-réseaux DRAM; et
dans laquelle chacun desdits sous-réseaux est couplé pour mémoriser des données de lecture dans seulement un ensemble respectif de registres de rangée, et chaque ensemble de registres de rangée est couplé pour recevoir et mémoriser des données de lecture provenant seulement d'un sous-réseau DRAM correspondant.

18. Mémoire selon la revendication 17, dans laquelle chacun desdits sous-réseaux DRAM est placé entre son ensemble respectif de registres de rangée (56) et les amplificateurs de détection (44) correspondant audit sous-réseau.
